Europäisches Patentamt

European Patent Office

Office européen des brevets

(11) Publication number : **0 466 508 A1**

# (12) EUROPEAN PATENT APPLICATION

(21) Application number : **91306356.6**

(22) Date of filing : **12.07.91**

(51) Int. Cl.⁵ : **H01L 29/784**

(30) Priority : **13.07.90 JP 186058/90**

(43) Date of publication of application :
**15.01.92 Bulletin 92/03**

(84) Designated Contracting States :
**DE FR GB NL**

(71) Applicant : **Matsushita Electronics
Corporation
1006, Oaza-Kadoma Kadoma-shi
Osaka 571 (JP)**

(72) Inventor : **Kayahara, Akihiro 1-7 Tobushi-cho
Ibaraki-shi
Osaka 567 (JP)**
Inventor : **Kawashima, Isamu 479 Ohoaza
Kawanami
Gokashyou-cho Kanzaki-gun
Shiga 529-14 (JP)**
Inventor : **Tanida, Hiroshiy 18-24-105
Uradouhonnmachi
Takatsuki-shi
Osaka 569 (JP)**
Inventor : **Yamanishi, Yuyi 11-504 Shimeien
Ibaraki-shi
Osaka 567 (JP)**

(74) Representative : **Crawford, Andrew Birkby et al
A.A. THORNTON & CO. Northumberland
House 303-306 High Holborn
London WC1V 7LE (GB)**

(54) **MOS-type semiconductor device and manufacturing method thereof.**

(57)   A semiconductor device comprises source, channel and drain regions arranged generally vertically, and the channel and drain regions have special parts which are of the same conductivity type as the channel and drain regions respectively but highly doped, and these highly doped special parts adjoin each other. Such a device can control load current freely and smoothly while withstanding high drain voltages.

## BACKGROUND OF THE INVENTION

This invention relates to a semiconductor device and more specifically to a metal oxide semiconductor field effect transistor (MOSFET) of vertical type for use in power regulation.

A semiconductor device comprising many MOSFETs of vertical type is well known. A vertical MOSFET in the semiconductor device comprises a silicon substrate including a source region, channel region, and a drain region. The source region occupies a small part of the substrate adjacent to a surface thereof and is of one conductivity type, typically of n-type. The channel region of the opposite conductivity type surrounds the source region and forms a pn-junction therebetween extending to the surface of the substrate, and the drain region of the first conductivity type occupies the remaining part of the substrate forming a pn-junction with the channel region and extending to the surface. The source region is provided with a source electrode connected at the surface thereof, and the drain electrode is attached to the drain region by the other surface of the substrate, while a gate electrode of polysilicon is placed on top of the surface of the channel region with an insulation layer of $SiO_2$ therebetween.

On applying a positive voltage to the gate of the FET, while keeping the source and drain electrodes at ground and positive potentials respectively, a channel is formed in the channel region under the gate and electrons flow from the source electrode to the drain electrode, through the source region, the upper part of the channel region, the upper part of the drain region, and the lower part of the drain region; and a current, of course, flows in the opposite direction. The current is satisfactorily controlled by the gate voltage, so that the device has been enjoying wide application in power regulation or switching of electronic apparatus.

The device, however, is easily destroyed by a high drain voltage, which often occurs when a inductive load such as a motor is being controlled, even if the voltage is not very high. If the drain voltage is excessive, breakdown first occurs at the pn-junction between the channel and drain regions, and breakdown current flows through the whole rectifying junction. Then the current crossing the junction through the under side of the source acts as a base current of a parasitic bipolar junction transistor formed by n-, p-, and n-regions of the source, channel, and drain regions of the FET, resulting in the so called second breakdown and destruction of the device by relatively low reverse voltage. Especially when the surrounding temperature is high, as is frequently the case in industrial applications, the resistance of the under part of the channel regions increases and the parasitic transistor works more actively.

## BRIEF SUMMARY OF THE INVENTION

It is an object of the present invention to provide an improved semiconductor device which can control load current freely and smoothly, while withstanding excessive drain voltage.

It is another object of the present invention to provide a manufacturing method suitable for such a semiconductor device.

In carrying out the above and other objects of the present invention, there is provided a semiconductor device comprising source, channel and drain regions arranged generally vertically, and the channel and drain regions each have a special part, which is of the same conductive type as the channel and drain regions. respectively but is highly doped, and these highly doped special parts adjoin each other.

In order that the present invention be more readily understood an embodiment thereof will now be described by way of example with reference to the accompanying drawings, in which:-

Fig. 1(a) is a plan view of a substrate of a semiconductor device according to the present invention, and Fig. 1(b) is a vertical sectional view of the semiconductor device taken along line 1A-1A of Fig. 1(a).

Fig. 2 is an enlarged vertical sectional view of the semiconductor device according to the invention.

Figs. 3-12 are vertical sectional views of the substrate showing the steps of manufacturing the device of the invention.

## DETAILED DESCRIPTION OF THE INVENTION

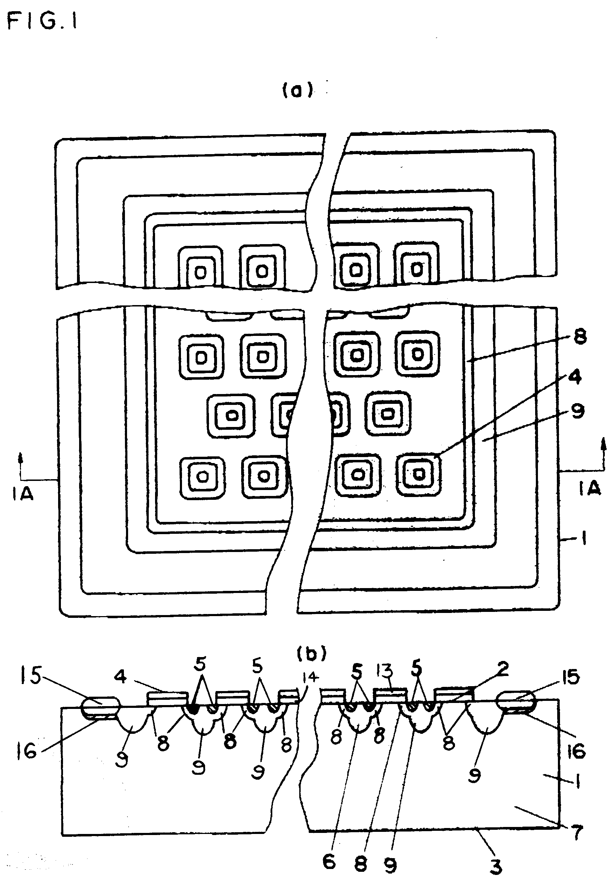

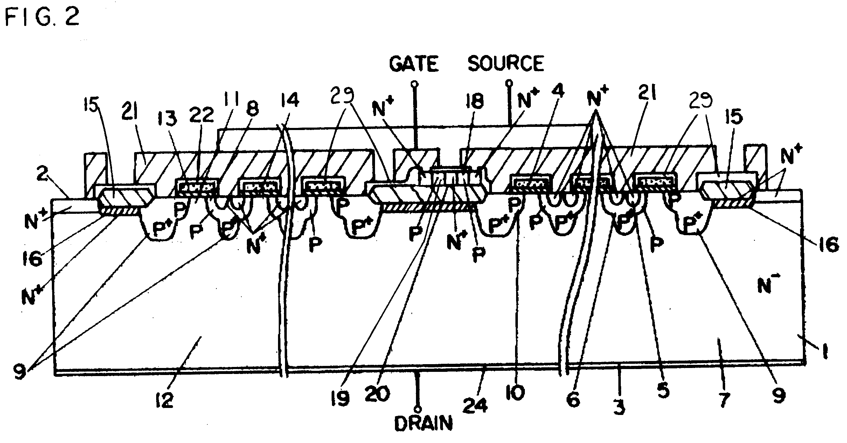

Referring to Figs. 1 and 2, a semiconductor device according to the present invention comprises a substrate or body 1 of a semiconductor material, typically of silicon, having an upper surface 2 and lower surface 3 and including many unit MOSFET 4 each of which comprises a first region 5, second region 6, and third region 7.

The first region 5, being of one conductivity type, typically of n-type, is of square frame form, and of high impurity concentration $n^+$, occupies a small part of the substrate 1, adjacent to the upper surface 2, to form the source region of the unit MOSFET 4. The second region 6, of the other conductivity type p, surrounds the first region 5 to form a pn-junction therewith extending to the upper surface 2 of the substrate and consists of two parts: a channel part 8 and a high impurity concentration part 9. The channel part 8 of $3\mu m$ depth is the part adjacent to the upper surface 2 of the substrate 1 and has a certain width around and depth beneath the first region 5. The high impurity concentration part 9 of $4\mu m$ depth occupies the part from inside of the frame of the first region 5 down to a point deeper than the lower surface 10 of the channel part 8. On the substrate 1, many such first and second regions 5 and 6 are arranged regularly, making lines having a half pitch difference with the next line, and with a certain distance between one another. Further, a $p^+$ -high impurity concentration part 9 runs near the circumference of the substrate forming a ring, surrounding the group of the above regions 5 and 6. The part of the substrate 1, remaining after the formation of the above first and second regions 5 and 6, constitutes the third region or the drain region 7. From the above description, it will be clear that the third region 7 comprises upper part 11 forming a network between the second regions 6 and one merged common lower part 12. The third region 7 acts as the common drain region 7 of each MOSFET 4. On top of the upper part 11 of the third region 7 and the channel part 8 of the second region 6, there is provided a gate electrode 13 of $0.48\mu m$ thick polysilicon with gate oxide 14 of $0.05\mu m$ thick thereunder. The parts of the upper surface 2 of the substrate 1 other than the parts of the first and second regions 5, 6 and the region therebetween is covered with thick oxide layer of $0.6\mu m$ field oxide 15. The part of the third region 7 under the field oxide 15 is a high impurity concentration part 16, which is of the same conductivity type as the other part of the third region 7 but highly doped. The high impurity concentration part 16 of the third region 7 along the circumference of the substrate 1, makes contact with the high impurity concentration part 9 of the near-by second region 6. On top of another part of the field oxide 15, there is provided a Zener diode 18, comprising a polysilicon layer having p-region 19 and n-region 20 alternately.

Each of the first and second regions 5 and 6 is attached with a common aluminium electrode 21 on the surface thereof, and the aluminium electrode 21 for many unit FETs 4 are connected to each other to form one common source electrode.

The gate electrodes 13 insulated by oxide layer 22 thereupon from the source interconnection 21 are also connected to a common gate electrode.

The drain region 7 is provided with a drain electrode 24 on the lower surface 3 of the substrate 1. The Zener diode 18 is connected between the gate electrode 13 and the first or source region 5 by aluminium interconnections.

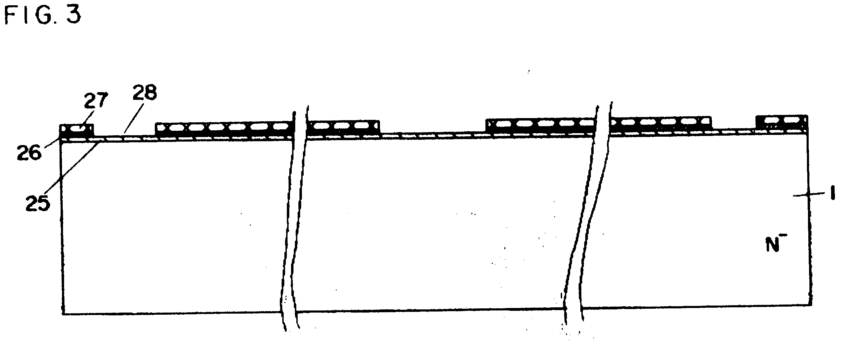

Referring to Fig 3-Fig. 12, the semiconductor device or vertical MOSFET as described above is manufactured as follows;

A semiconductor substrate 1 of one conductivity type, for example n-type is prepared, and is covered by a first oxide layer 25 of $0.055\mu m$ thickness. A silicon nitrite layer 26 of $0.095\mu m$ thick is grown by CVD, on the first oxide layer 25.

A part 28 of the silicon nitrite layer 26 is removed by using photolithography and etching of a photoresist 27, the part 28 ultimately being used to formed to the field oxide.

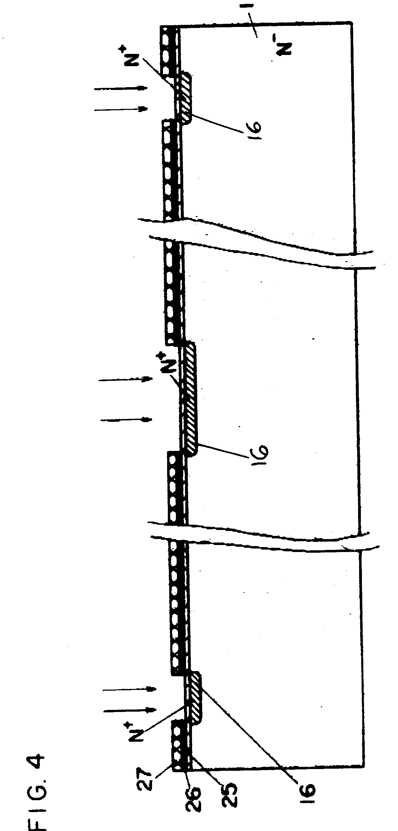

Phosphor is ion-implanted into the substrate 1 using, as a mask, both the photoresist 27 remaining on the nitrite layer 26 and the silicon nitrite layer 26 itself so as to form in the surface 1 of the substrate the high concentration part 16 of $n^+$ as indicated in Fig. 4.

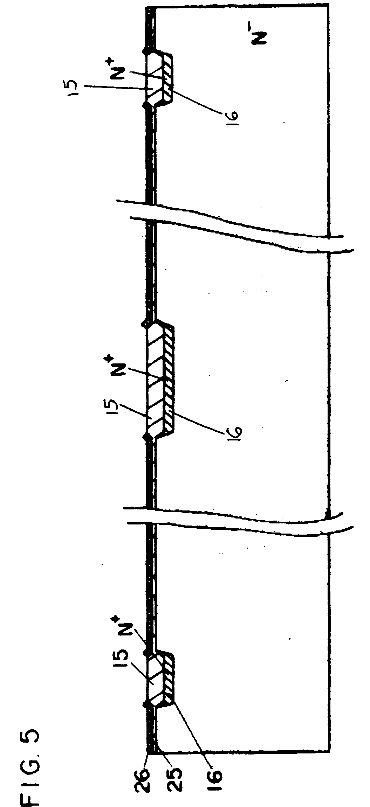

The photoresist 27 on the nitrite layer 26 is then removed, and the second oxide layer or field oxide 15 of 0.6um thickness is formed on the part 16 as shown in Fig. 5.

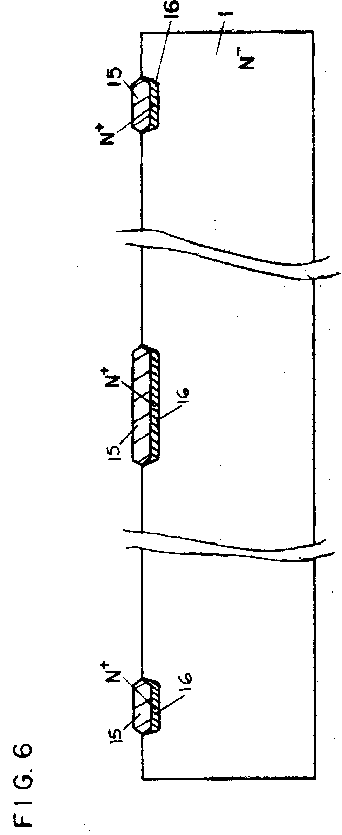

Both the nitrite layer 26 and the first oxide layer 25 are then removed to expose the upper surface of the substrate other than the part covered by the above second oxide layer of field oxide 15 (Fig. 6).

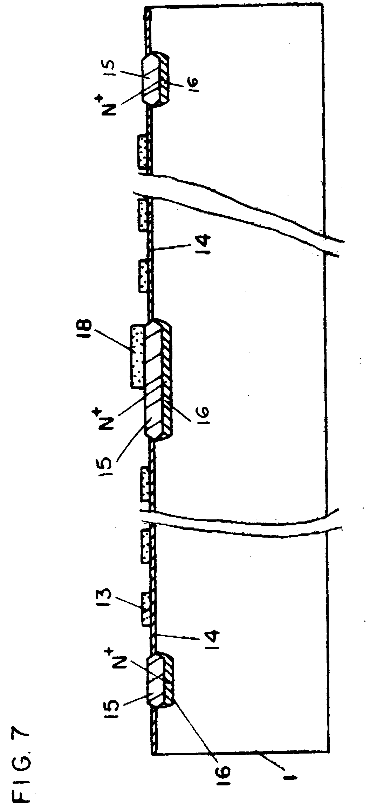

An oxide layer of $0.05\mu m$ is thermally grown all over the substrate 1 to become later the gate insulation layer 14. A polysilicon layer is grown all over the substrate by CVD, the thickness being $0.48\mu m$, and by lithography and etching of photoresist, the polysilicon layer is removed leaving the part for gate electrode 13 and the part for the Zener diode 18 on the field oxide 15 (Fig. 7).

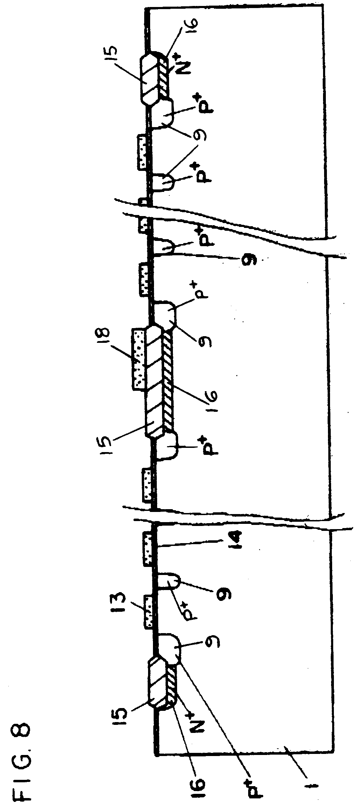

As shown in Fig. 8, after patterning of photoresist, boron is ion-implanted into the parts of the surface of the substrate adjacent to and between the gates 13 to make these parts the high impurity concentration parts 9, the window of the photoresist mask being a little smaller than the window between the two gates and the depth of parts 9 being $0.1\mu m$.

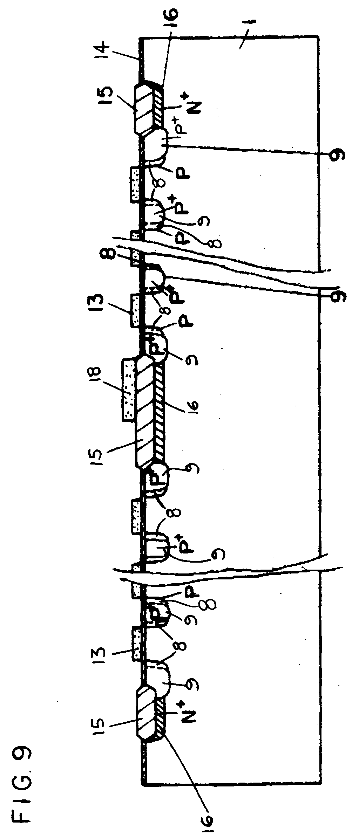

After removing the photoresist as indicated in Fig. 9, boron is ion-implanted into the surface 2 of the substrate with the gates 13 forming the mask so as to implant those areas which were previously masked by photoresist and thus form the channel parts 8 of the second region 6, depth being $0.1\mu m$.

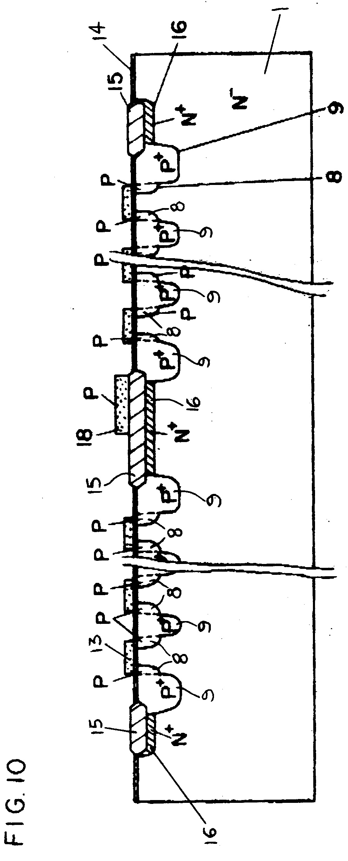

Then the substrate is heated to a high temperature to drive in the impurity of the second region and to make the depth of the parts 9 and parts 8, about $4\mu m$ and $3\mu m$, respectively and to spaced laterally the implanted areas as shown in Fig. 10.

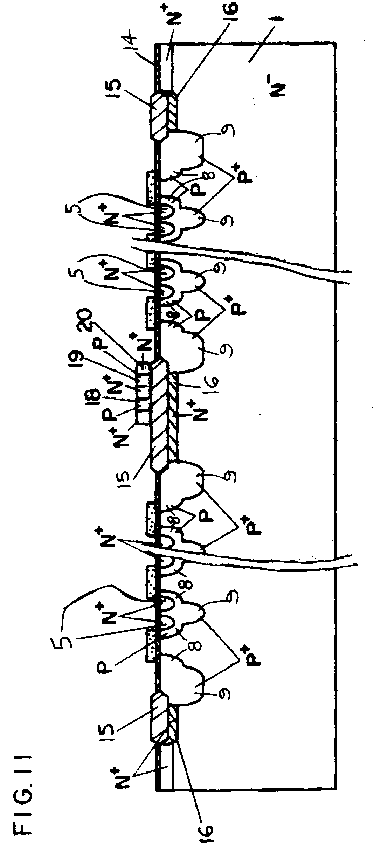

After patterning, n-type impurity is ion implanted into the above formed second region 8 to form the first or source region 5, and at the same time into the part 18 of the polysilicon layer on the field oxide for the Zener diode 18 to form $n^+$-part therein, the $n^+$ parts 20 being formed with a certain distance between themselves, and leaving p-type parts 19 between them so that a Zener diode 18 is formed by these p-and n-regions 19, 20 lying alternately as shown in Fig. 11.

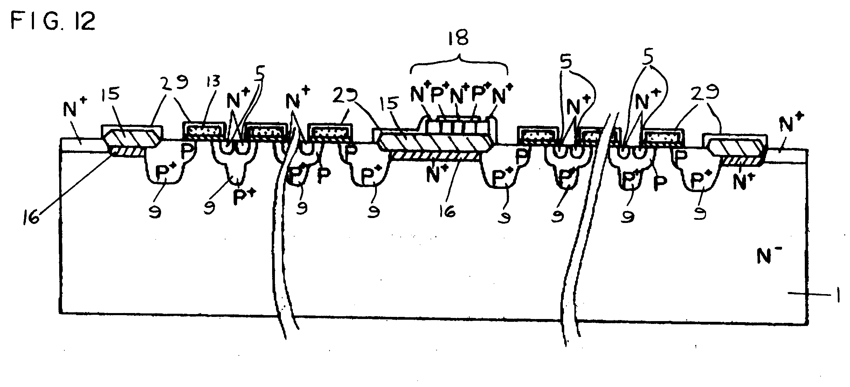

A phosphosilicate glass (PSG) layer 29 is grown on the substrate, and windows for interconnections are made in it (Fig. 12).

The substrate is covered all over with an aluminium film by vacuum deposition and then the aluminium film is removed leaving the parts necessary for interconnection and is provided with a drain electrode 24 to form the final device as shown in Fig. 2.

In the semiconductor device according to the invention, a channel is induced, by a positive voltage applied to the gate with the drain and source held at positive and ground potential respectively. In the channel part 8 of the second region 6, electrons flow from the source region 5 through the channel region 6 and the upper part 11 of the drain region 7 to the lower part 12 of the drain region 7.

If any excessive reverse voltage is applied between the drain and source of the semiconductor device breakdown occurs at the pn-junction between the channel part of the second region and the high impurity part of the third region, and the resulting breakdown current runs to the aluminium electrode without passing the bottom part of the channel part of the second region, so that no parasitic transistor effect is created and the device can withstand a very high destroying energy, e.g. 10 times larger than the conventional one.

Further if the second region 6 of the device is provided, according to the invention, with high impurity concentration part 9 of the p-type, breakdown occurs much easier between this part and the high impurity part 16 of the third region 7, resulting in more advanced protection of the device, and in a wider safe operation area, especially at high temperatures.

As the device according to the invention is provided with a bidirectional Zener diode, gate oxide can be protected from electrostatic breakdown, and because the Zener diode is laid on a thick field oxide, it has, at any drain voltage, no effect on the operation of the device.

Also, according to the manufacturing method of the invention including local oxidation method and ion-implantation combined, the high impurity concentration parts are formed without much troublesome process.

Further, according to the manufacturing method of the invention the Zener diode can be made simultaneously with the formation of the first region or the source region with no additional process for the former.

**Claims**

1 A semiconductor device comprising:
a semiconductor substrate (1) including
a first region (5) second region (6) and third region (7);
the first region (5) being of one conductivity type and occupying a small part of the substrate adjacent to the upper surface thereof,
the second region (6) being of opposite conductivity type, surrounding the first region (5) having a pn-junction therewith which extends to the upper surface, and including channel region (8) which is formed by the part adjacent to the upper surface,
the third region (7) being of the first conductivity type, consisting of the remaining part of the substrate, having a pn-junction with the second region (6) which extends to the upper surface and including a high impurity concentration part (9) which lies adjacent to the second region and the upper surface,
and having
a gate electrode (13) on the channel region with gate oxide (14) therebetween, a source and a drain electrode respectively connected with the first region (5) and the third region (6).

2. A semiconductor device according to claim 1, wherein the second region further includes a high concentration part which lies under the first region.

3. A semiconductor device according to claim 1 or 2, wherein the substrate is provided with a Zener diode connected between the gate and source.

4. A semiconductor device according to claim 3, wherein the Zener diode is on top of the surface of the substrate with oxide layer therebetween.

5. Method of manufacturing semiconductor device comprising the steps of;
(a) forming a first oxide layer on a semiconductor substrate of one conductivity type.
(b) forming silicon nitride layer on the first oxide layer, removing, by way of photolithography and etching of photoresist, a part of silicon nitride layer, the part being to be covered by a field oxide,
(c) ion-implanting impurity of the one conductivity type into the said part of substrate to be covered by field oxide to form the region with impurity concentration higher than that of the substrate,
(d) removing the photoresist layer on the nitride film,
(e) growing second oxide layer on the part of the surface having higher impurity concentration.
(f) removing the nitride layer and the oxide layer to expose the surface of the substrate other than the part of the surface having high impurity concentration.
(g) growing third oxide layer all over the substrate,
(h) growing polysilicon layer all over the third oxide layer,
(i) removing a part of polysilicon layer by lithography and etching of photoresist, leaving the parts to become gate electrode on the gate oxide and the parts on the field oxide to become a Zener diode,
(j) patterning of photoresist so as to make a window smaller than the space between the gates and ion-implanting impurity through the window into the parts of semiconductor substrate adjacent to the surface between the gates, to form a high concentration part in the second region,
(k) removing the photoresist and ion-implanting through the gate oxide as mask into the parts of silicon substrate adjacent to the surface between the gate, to form the channel part of the second region,
(l) patterning and ion-implanting impurity of the one conductivity type into the second region to form the first region, and at the same time, into the part of the polysilicon layer on the field oxide, to change a part thereof to the one conductivity type.

FIG.1

(a)

8
4
9
1A
1A
1

(b)

5 5 5 13 5 2
15 4 14 15
16 8 8 8 8 8 8
9 9 9 9 16
6 8 9 1
7
6 8 9 3

# FIG. 2

GATE    SOURCE

DRAIN

EP 0 466 508 A1

FIG. 3

FIG. 4

FIG. 5

FIG. 6

FIG. 7

FIG. 8

FIG. 9

FIG. 10

FIG. 11

EP 0 466 508 A1

FIG. 12

**European Patent Office**

## EUROPEAN SEARCH REPORT

Application Number

EP 91 30 6356

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 9, no. 310 (E-364)(2033), 6 December 1985; & JP - A - 60144972 (TOSHIBA) 31.07.1985 * whole document * | 1,2 | H 01 L 29/784 |
| Y | idem | 3-5 | |
| Y | GB-A-2 103 877 (HITACHI) * abstract; figures 8A-12 * | 3,4 | |
| Y | EP-A-0 179 407 (SGS MICROELETTRONICA) * figures 1a-1f; abstract * | 5 | |
| A | PATENT ABSTRACTS OF JAPAN vol. 13, no. 53I (E-851)(3879), 28 November 1989; & JP - A - 1217976 (NEC) 31.08.1989 * whole document * | 3,4 | |
| A | PATENT ABSTRACTS OF JAPAN vol. 7, no. 182 (E-192)(1327), 1983; & JP - A - 5887873 (HITACHI SEISAKUSHO) 25.05.1983 * whole document * | 3,4 | TECHNICAL FIELDS SEARCHED (Int. Cl.5) H 01 L |

The present search report has been drawn up for all claims

| Place of search | Date of completion of the search | Examiner |
|---|---|---|
| BERLIN | 14-10-1991 | JUHL A. |